# EUROPÄISCHE PATENTSCHRIFT

(11) **EP 2 678 889 B1**
(45) Veröffentlichungstag und Bekanntmachung des Hinweises auf die Patenterteilung: **21.10.2015**
(21) Anmeldenummer: 12710171.5
(22) Anmeldetag: 23.02.2012
(51) Int. Cl.: H01L 41/053, H01L 41/047, H02N 2/04

(54) **KRAFTMODUL MIT SUBMODULEN UND EINEM ANSTEUERUNGS- UND SICHERUNGSMODUL ZUR HOCHDYNAMISCHEN KRAFTERZEUGUNG**
FORCE MODULE WITH SUB-MODULES AND A CONTROLLING AND PROTECTION MODULE FOR GENERATING FORCES IN A HIGHLY DYNAMIC MANNER
MODULE DE FORCE DOTÉ DE SOUS-MODULES ET D'UN MODULE DE COMMANDE ET DE SÉCURITÉ POUR LA GÉNÉRATION HAUTEMENT DYNAMIQUE DE FORCES

(30) Priorität: 24.02.2011 DE 102011004690
(43) Veröffentlichungstag der Anmeldung: 01.01.2014
(73) Patentinhaber: CeramTec GmbH, 73207 Plochingen (DE)
(72) Erfinder: KELNBERGER, Alfons, 96047 Bamberg (DE); SCHREINER, Hans-Jürgen, 91217 Hersbruck (DE); BINDIG, Reiner, 95463 Bindlach (DE); BRANDT, Jürgen, 92237 Sulzbach-Rosenberg (DE)
(74) Vertreter: Scherzberg, Andreas Hans
(86) Internationale Anmeldenummer: PCT/EP2012/053077
(87) Internationale Veröffentlichungsnummer: WO 2012/113869

(56) Entgegenhaltungen:
- WO-A1-00/51190
- DE-A1- 19 954 310
- DE-A1-102007 033 943
- DE-A1-102007 041 636
- US-A1- 2007 052 325
- US-A1- 2008 202 664

## Beschreibung

Die Erfindung betrifft ein Kraftmodul zur hochdynamischen Krafterzeugung durch Zusammensetzen einer Mehrzahl an Piezoaktoren zum Anschluss an einer Spannungsquelle und deren Verwendung.

Gegenwärtiger Stand der Technik zur hochdynamischen Krafterzeugung sind piezoelektrische Niederspannungsaktoren als Piezoaktoren, die in Vielschichtbauweise aufgebaut sind. Das Arbeitsvermögen und damit auch das Kraftvermögen werden im Wesentlichen bestimmt durch das Volumen der Piezoaktoren, dem prozessbedingt Grenzen gesetzt sind. Typischerweise erzeugbare Kräfte liegen in der Größenordnung von lediglich einigen kN.

Die US 2008/0202664 A offenbart eine piezoelektrische Baueinheit zur aktiven Vibrationsdämpfung, bei der eine Vielzahl von plattenförmigen Piezoelementen in mehreren Lagen angeordnet und über elektrisch leitende Schichtsegmente mit einer Anschlusseinheit verbunden sind.

Mit den bekannten Hochvoltaktoren als Piezoaktoren, die wegen des Aufbaus aus diskreten Piezoscheiben wesentlich größer als piezoelektrische Niederspannungsaktoren gebaut werden können, werden zwar höhere Kräfte erreicht, allerdings lässt sich damit keine Ortsauflösung realisieren. Auch die hohe Betriebsspannung erlaubt nicht den Einsatz im rauen Umfeld der Maschinentechnik.

Da es sich bei Piezoaktoren um relativ empfindliche elektrokeramische Materialien handelt, können diese nicht ohne weitere konstruktive Maßnahmen für den erfindungsgemäßen Anwendungsbereich eingesetzt werden. Einfaches Zusammensetzen von vielen Piezoaktoren an einer Spannungsquelle führt zu unkontrollierten elektrischen Zuständen (hot spots, Serienausfälle durch Dominoeffekt etc.).

Andere Systeme, basierend auf hydraulischen oder elektrodynamischen Prinzipien, erreichen entweder nicht die geforderte hohe Dynamik, die geforderte Ortsauflösung oder benötigen hohe Energie zum Halten der Kräfte. Speziell Hydraulikzylinder scheiden auch schon wegen der zu hohen Einbaumaße aus.

Der Erfindung liegt die Aufgabe zugrunde, ein Kraftmodul zu schaffen, das hochdynamisch und ortsaufgelöst mechanische Kräfte im Bereich von einigen 100 kN erzeugt. Es sollen Ansprechzeiten realisiert werden, die mindestens im msec Bereich liegen, die Ortsauflösung soll mindestens im Quadratzentimeter-Bereich stattfinden.

Das Kraftmodul soll außerdem in einem extrem anspruchsvollen Fertigungsumfeld einsetzbar sein, unter denen es dauerhaft externen Kräften, insbesondere Stoßkräften, von mehreren 10 bis 100 kN ausgesetzt ist und diesen standhalten muss. Das Kraftmodul soll zur Gewährleistung einer langen Lebensdauer außerdem zuverlässig vor Umwelteinflüssen geschützt sein, beispielsweise vor Feuchtigkeit oder chemischen Einflüssen.

Diese Aufgabe wird erfindungsgemäß gelöst durch ein Kraftmodul gemäß Anspruch 1. Das Kraftmodul besteht aus mindestens zwei Submodulen mit jeweils mindestens zwei Piezoaktoren und deren elektrischen Kontaktierungselementen und einem Ansteuerungs- und Sicherungsmodul für die Piezoaktoren in den Submodulen, wobei alle elektrischen Kontaktierungselemente der Submodule in das Ansteuerungs- und Sicherungsmodul geführt sind. Damit addiert sich das Kraftvermögen der einzelnen Piezoaktoren und es können die gemäß der Aufgabenstellung hohen Gesamtkräfte erreicht werden.

Erfindungsgemäß stellen die elektrischen Kontaktierungselemente für jeden einzelnen Piezoaktor im Submodul zwei elektrische Leiterbahnen bereit, so dass jeder Piezoaktor im Submodul einzeln und unabhängig von anderen ansteuerbar ist.

Erfindungsgemäß sind die elektrischen Kontaktierungselemente ein Flexboard mit elektrischen Leiterbahnen und sind die Außenelektroden der Piezoaktoren mit den Leiterbahnen elektrisch verbunden. Flexboards sind extrem dünn und benötigen daher wenig Platz. Außerdem lassen sie sich einfach und abgedichtet aus einem Gehäuse herausführen. Unter einem Flexboard wird ein flexibler elektrisch isolierender flacher dünner Trägerkörper mit aufgebrachten Leiterbahnen verstanden.

Bevorzugt ist jedes Flexboard endseitig mit einem Anschlussstecker versehen. Dies erleichtert das elektrische Ankoppeln der Submodule an das Ansteuerungs- und Sicherungsmodul.

In bevorzugter Ausführungsform ist jedes Submodul eingehaust und weist ein Gehäuseteil mit Basisplatte und Deckel auf um die Piezoaktoren vor Umwelteinflüssen zu schützen und führen nur die elektrischen Kontaktierungselemente aus dem Gehäuse abgedichtet heraus. Das Submodul ist dadurch zuverlässig vor Umwelteinflüssen geschützt.

In bevorzugter Ausführungsform sind zwischen den Piezoaktoren in den Submodulen keramische Materialien eingebracht. Dies führt zur besseren elektrischen Isolation der einzelnen Piezoaktoren untereinander.

Bevorzugt sind alle Submodule identisch aufgebaut. Dies vereinfacht die Herstellung. Erfindungsgemäß sind in den Submodulen keine elektronischen Bauteile, sondern diese ausschließlich im Ansteuerungs- und Sicherungsmodul angeordnet. Durch diese Maßnahme können die Submodule klein und kompakt gebaut sein.

In einer Ausführungsform ist im Ansteuerungs- und Sicherungsmodul für jeden einzelnen Piezoaktor ein Leistungsverstärker angeordnet. So ist zusätzlich zu den Sicherungen auch ein Leistungsverstärker für jeden einzelnen Piezoaktor vorhanden, in dem die zur Ansteuerung der einzelnen Piezoaktoren erforderlichen elektrischen Leistungen/Ströme über Transistoren gesteuert werden. Da die einzelnen Piezoaktoren individuell ansprechbar sind kann das Kraftmodul nahezu beliebige dynamische Kraftverteilungen realisieren.

Die Kontrolle und Steuerung der Vorrichtung erfolgt über leicht handhabbare Steuersignale, die von einer Steuereinheit, z.B. einem Computer erzeugt und über einen Datenbus in das Ansteuerungs- und Sicherungsmodul geführt werden, was einen großen Vorteil darstellt.

Bevorzugt weist das Kraftmodul ein Kraftmodul-Gehäuseteil mit Grund- und Deckplatte auf und bestehen alle Teile aus Stahl, insbesondere gehärtetem Stahl. Hierdurch sind die empfindlichen Piezoaktoren und die elektronischen Bauteile vor hohen mechanischen Belastungen dauerhaft geschützt.

Bevorzugt sind die Submodule im Kraftmodul-Gehäuseteil mit der Grund- und Deckplatte über Dehnungsschrauben vorgespannt, wodurch keine Zugkräfte in die Piezoaktoren eingeleitet werden.

Bevorzugt ist am Kraftmodul ein Anschlusskabel befestigt, deren elektrische Leiter in das Ansteuerungs- und Sicherungsmodul geführt sind. Bevorzugt ist auch eine Busleitung in das Ansteuerungs- und Sicherungsmodul geführt.

Bevorzugt wird das erfindungsgemäße Kraftmodul zur Steuerung von Fließvorgängen durch lokale Klemmung bei mechanischen Umformprozessen in der Automobilindustrie verwendet.

Die Erfindung zeichnet sich dadurch aus, dass eine bestimmte Anzahl von Piezoaktoren, insbesondere piezoelektrische Vielschichtaktoren zu einem Submodul zusammengefasst werden und diese Submodule zu einem Kraftmodul bestehend aus mehreren Submodulen zusammengefasst und definiert angeordnet werden. Damit addiert sich das Kraftvermögen der einzelnen Piezoaktoren und es können hohe Gesamtkräfte erreicht werden.

Die Piezoaktoren in den Submodulen sind einzeln und unabhängig voneinander hochdynamisch ansteuerbar, womit eine hohe Ortsauflösung erreicht wird.

Die Submodule sind konstruktiv so gestaltet, dass sie die elektrische Isolation der einzelnen Piezoaktoren gewährleisten und einen zuverlässigen Schutz vor Umwelteinflüssen sicherstellen.

Das Kraftmodul beinhaltet zusätzlich zu den Submodulen ein Ansteuer- und Sicherungsmodul, mit der die Piezoaktoren der Submodule einzeln elektrisch angesteuert und gesichert werden und so kontrollierte und beherrschte elektrische Zustände erreicht werden.

Das Kraftmodul ist so ausgeführt, dass es den mechanischen Schutz der Submodule und des Ansteuer- und Sicherungsmoduls vor beispielsweise hohen Stoßbelastungen im Betrieb gewährleistet.

Eine mögliche Ausführungsform der Erfindung besteht darin, dass die Submodule zehn piezoelektrische Vielschichtaktoren beinhalten, die in einer Reihe angeordnet und einzeln ansteuerbar sind. Es ist natürlich auch eine andere Anordnung mit einer anderen Anzahl der einzelnen Piezoaktoren möglich, z. B. als 3x3 bzw. NxN Matrixanordnung.

Die Piezoaktoren sind in dieser Ausführungsform Standardaktoren, so wie sie beispielsweise bei Common Rail Diesel Injektoren eingesetzt werden.

Die Kontaktierung der einzelnen Piezoaktoren erfolgt über Flexboardleiterbahnen, d.h. über Flexboards mit aufgebrachten Leiterbahnen oder ähnlich platzsparenden Methoden, mit denen gleichzeitig auch der Kontaktierungs- und Montageaufwand erheblich minimiert werden kann. Dies stellt einen entscheidenden Vorteil gegenüber herkömmlichen Kontaktierungsmethoden, beispielsweise mit einzelnen Anschlusslitzen dar.

Die Verwendung von einer Mehrzahl an Submodulen im Kraftmodul hat den entscheidenden Vorteil, dass rein statistisch sowohl eine relativ hohe Ausbeute als auch eine geringe Ausfallwahrscheinlichkeit sichergestellt wird. Jedes einzelne Submodul wird vor dem Einbau in das Kraftmodul geprüft.

Beispielsweise liegt bei einer Ausbeute- bzw. Überlebenswahrscheinlichkeit des einzelnen Piezoaktors von 99% die Ausbeute- bzw. Überlebenswahrscheinlichkeit in einem System von N Piezoaktoren bei 0,99^{N}, also beispielsweise bei N = 100 bei nur 37%. In einem System von M Submodulen also bei 0,99^{M}. Bei M = 10 liegt sie bei wesentlich höheren 90%.

Die elektrische Entkopplung der einzelnen Piezoaktoren im Submodul hat weiterhin den Vorteil, dass jeder Piezoaktor einzeln und individuell ansteuerbar ist. Ein Serienausfall durch einen Dominoeffekt wird so verhindert.

Außerdem ist die Überprüfbarkeit jedes einzelnen Piezoaktors gewährleistet, beispielsweise während der Montage oder im Betrieb. Damit ist ein ausgefallener Piezoaktor in einem Submodul lokalisierbar und zumindest zum Teil kompensierbar, d.h. durch entsprechende Nachregelung der anderen Piezoaktoren kann die Funktionalität des Submoduls aufrechterhalten werden.

Eine Überprüfung der Piezoaktoren kann über herkömmliche Methoden, wie z.B. Impedanz- oder Ladungsanalyse erfolgen.

Die Piezoaktoren sind in einer Reihe auf einer Basisplatte, beispielsweise aus einem gehärteten Stahl, des Submoduls angeordnet und mittels geeigneter Werkzeuge darauf ausgerichtet, so dass Fehlstellungen einzelner Piezoaktoren ausgeschlossen werden.

Zur weiteren Einhausung der Piezoaktoren ist ein Gehäuseteil auf der Basisplatte angeordnet, welches die Reihe der Piezoaktoren umschließt. Dieses Gehäuseteil besteht beispielsweise aus einem Blechbiegeteil und weist einen Durchbruch für die Flexleiterbahnen auf. Auf dem Gehäuseteil befindet sich ein Deckel, so dass insgesamt eine komplette Einhausung bzw. Kapselung der Piezoaktoren sichergestellt ist.

Zur besseren elektrischen Isolation der einzelnen Piezoaktoren untereinander innerhalb des Submoduls sind zwischen die Piezoaktoren elektrisch isolierende Bauteile oder Substanzen, beispielsweise aus keramischen Materialien, eingebracht. Diese sind in einer bevorzugten Ausführungsform dünne Platten aus Aluminiumoxid. Es können aber auch andere keramische Werkstoffe oder keramische Partikel sein, die mit in die Vergussmasse eingebracht werden, oder Separatorfolien aus hochdurchschlagfesten Materialien. Im Falle eines Überschlags eines einzelnen Piezoaktors hat dies den Vorteil, dass sich der Schaden nicht auch auf die benachbarten Piezoaktoren auswirkt und das Submodul funktionell d.h. intakt bleibt.

Die Piezoaktoren in den Submodulen sind zum Schutz vor Umwelteinflüssen, beispielsweise vor chemischen Substanzen oder Feuchtigkeit, vergossen. Dazu eignen sich Vergussmassen beispielsweise aus Silikon, Polyurethan oder Epoxidharz. Die Vergussmasse fixiert Basisplatte, Piezoaktoren, Gehäuseteil und Deckel.

Die so aufgebauten Submodule stehen über z. B. Flexleiterbahnen mit integriertem Anschlussstecker in elektrischer Verbindung mit dem Ansteuerungs- und Sicherungsmodul. Die Trennung der Submodule von dem Ansteuerungs- und Sicherungsmodul hat den entscheidenden Vorteil, dass die Submodule sehr kompakt gebaut werden können, weil keine zusätzlichen elektronischen Bauteile, wie z.B. elektrische Sicherungen (z.B. Mini Fuses, PTC Elemente, Zener Dioden oder andere Sicherungselemente) an die Piezoaktoren angebracht werden müssen. Die einzelne Absicherung der Piezoaktoren, die nötig ist um bei Ausfall eines Piezoaktors einen Komplettausfall des Submoduls zu verhindern, erfolgt somit in einer separaten modularen Einheit.

In einer Ausführungsvariante beinhaltet das Ansteuerungs- und Sicherungsmodul zusätzlich zu den Sicherungen auch einen Leistungsverstärker für jeden einzelnen Piezoaktor, in dem die zur Ansteuerung der einzelnen Piezoaktoren erforderlichen elektrischen Leistungen / Ströme über Transistoren gesteuert werden. Die einzelnen Piezoaktoren sind individuell ansprechbar und somit ist das erfindungsgemäße Kraftmodul in der Lage, nahezu beliebige dynamische Kraftverteilungen zu realisieren.

Die Kontrolle und Steuerung der Kraftmodule erfolgt über leicht handhabbare Steuersignale, die von einer Steuereinheit, z. B. einem Computer erzeugt und über einen Datenbus dem Ansteuerungs- und Sicherungsmodul zugeführt werden, was einen großen Vorteil darstellt.

Die zugehörige Schaltungstechnik basiert auf den bekannten Prinzipien der Leistungsverstärkertechnik.

In einer einfacheren Variante wird jeweils ein Submodul über einen Leistungsverstärker angesteuert. Dies vereinfacht den Aufbau.

In einer noch einfacheren Variante enthält das Ansteuer- und Sicherungsmodul nur Sicherungen und Überspannungsableiter. In diesem Fall können bei Ansteuerung des gesamten Kraftmoduls als einer Einheit oder der einzelnen Submodule die einzelnen Ansteuerleitungen nach außen geführt werden und an externe Leistungsverstärker angeschlossen werden. Die Piezoaktoren wären dann allerdings nicht mehr individuell ansprechbar.

Erfindungsgemäß werden die Submodule und das Ansteuer- und Sicherungsmodul zu einem Kraftmodul zusammengefasst.

Nachfolgend wird die Erfindung anhand von Figuren weiter erläutert.

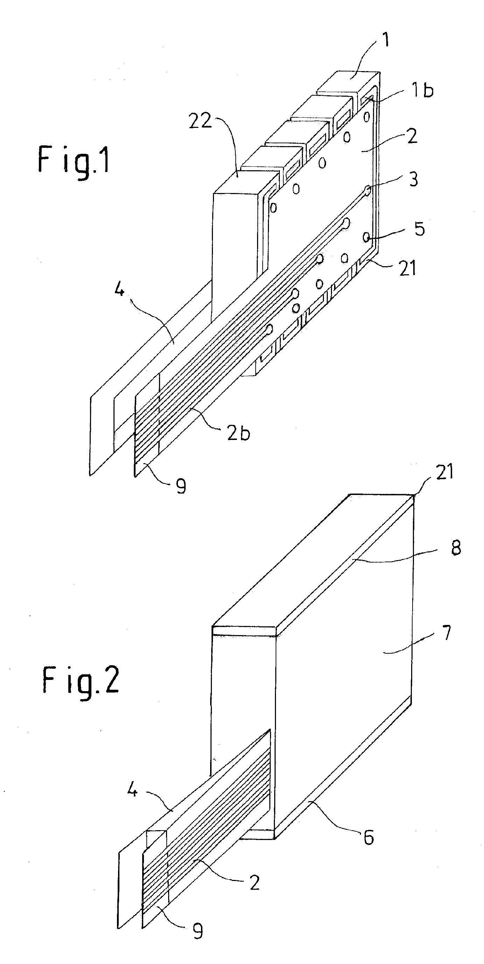

In den Figuren 1 und 2 ist ein Submodul 21 gezeigt, wobei Figur 1 den inneren Aufbau und Figur 2 eine Außenansicht zeigt. Im Inneren des Submoduls 21 sind in der hier gezeigten Ausführungsform fünf Piezoaktoren 1 in Reihe angeordnet. Die Innenelektroden (nicht gezeigt) jeder Polarität eines Piezoaktors sind über Außenelektroden 1 b parallel geschaltet. Die Piezoaktoren 1 sind alle Vielschichtaktoren.

Auf die Außenelektroden 1 b einer Polarität ist jeweils ein Flexboard 2 mit Leiterbahnen 2b aufgelötet. Dabei ist jeder Außenelektrode 1 b jedes Piezoaktors 1 eine Leiterbahn 2b auf dem Flexboard 2 zugeordnet. Die Lötverbindung (Vias mit Durchkontaktierung) zur elektrischen Verbindung der Außenelektroden 1 b mit der Leiterbahn 2b ist mit dem Bezugszeichen 3 gekennzeichnet. Mit dem Bezugszeichen 5 ist die Lötverbindung (Vias mit Durchkontaktierung) zur mechanischen Verbindung der Außenelektroden 1 b mit dem Flexboard 2, d.h. die Stabilisierung der Piezoaktor-Flexboardanordnung gezeigt.

Neben den Leiterbahnen 2b ist auch ein Masseanschluss 4 auf dem Flexboard 2 vorhanden. Jedes Flexboard 2 ist endseitig mit einem Anschlussstecker 9 (hier nur schematisch gezeigt) angeordnet.

Figur 2 zeigt ein Submodul 21 von außen. Jedes Submodul 21 ist eingehaust und besteht aus einem Gehäuseteil 7, einer Basisplatte 6 und Deckel 8. Nur das Flexboard 2 mit den Leiterbahnen 2b ist aus dem Gehäuse herausgeführt und zwar abgedichtet, so dass keine Umwelteinflüsse in das Gehäuse gelangen können.

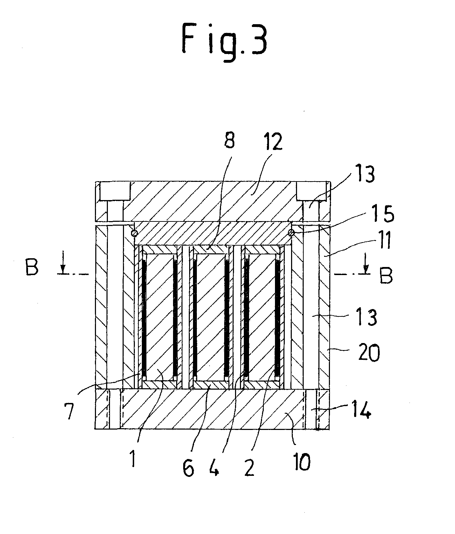

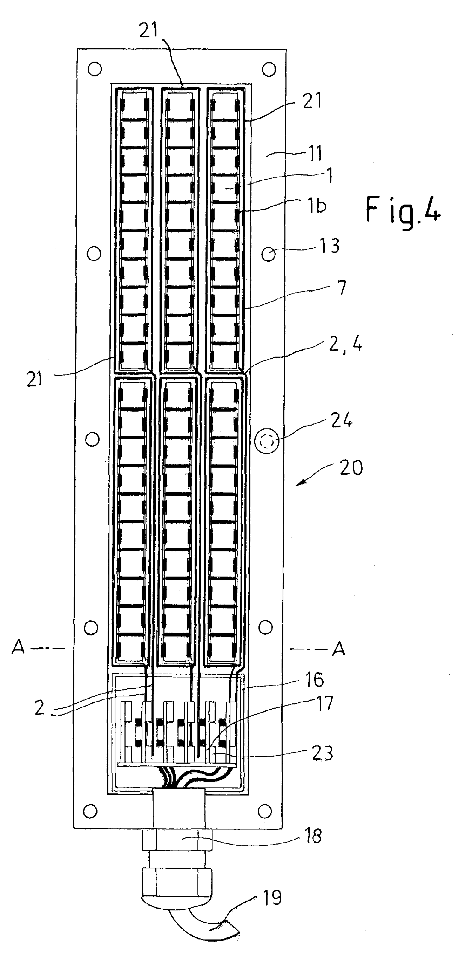

In den Figuren 3 und 4 ist ein erfindungsgemäßes Kraftmodul 20 gezeigt. Figur 3 zeigt den Schnitt A-A von Figur 4 und Figur 4 zeigt den Schnitt B-B von Figur 3.

Das Kraftmodul 20 besteht aus sechs Submodulen 21, die in das Gehäuse des Kraftmoduls 20 eingeschoben oder eingesteckt wurden, wobei jeweils drei Submodule 21 nebeneinander angeordnet sind. Insgesamt entsteht so ein Kraftmodul 20 mit sechzig Piezoaktoren 1. Die einzelnen Submodule 21 stehen alle in elektrischem Kontakt mit dem Ansteuer- und Sicherungsmodul 16. Es können natürlich auch mehr oder weniger Submodule 21 zu einem Kraftmodul 20 in beliebiger Weise zusammengefasst werden.

Das Kraftmodul 20 hat die Aufgabe, die empfindlichen Piezoaktoren 1 und die elektronischen Bauteile in dem Ansteuer- und Sicherungsmodul 16 vor hohen mechanischen Belastungen dauerhaft zu schützen und besteht in dem Ausführungsbeispiel aus einer massiven Grund- 10 und Deckplatte 12 aus Stahl, beispielsweise aus gehärtetem Stahl, und einem ebenfalls massivem Kraftmodul-Gehäuseteil 11.

Die Deckplatte 12 ist konstruktiv so gestaltet, dass sie durch das Kraftmodul-Gehäuseteil 11 beim Zusammenbau geführt wird. Das wird hier durch einen umlaufenden Absatz realisiert. An diesem Absatz befindet sich zusätzlich ein Dichtmittel, hier ein O-Ring 15, der das Kraftmodul-Gehäuseteil 11 vor Umwelteinflüssen schützt.

In der Deckplatte 12, in dem Kraftmodul-Gehäuseteil 11 und in der Grundplatte 10 befinden sich Bohrungen 13 mit jeweils einem Gewinde 14, die regelmäßig über den Umfang des Kraftmoduls 20 angeordnet sind. In diesem Ausführungsbeispiel reichen zehn Bohrungen 13 aus. Sie dienen zur Aufnahme von Dehnungsschrauben 24, mit denen die Submodule 21 im Kraftmodul 20 vorgespannt werden und durch die die drei Komponenten 10, 11, 12 des Gehäuses fest miteinander verbunden werden.

Die Dehnungsschrauben 24 wirken mit einer konstanten Kraft auf die Submodule 21, spannen diese vor und verhindern, dass Zugkräfte in die Piezoaktoren 1 eingeleitet werden. Die Dimensionierung der Dehnungsschrauben 24 in Bezug auf ihre Steifigkeit und ihre Position muss so gewählt sein, dass die Piezoaktoren 1 eine ausreichend hohe Dehnung aufweisen.

Weil die Piezoaktoren 1 prozessbedingt geringfügig unterschiedliche Höhen aufweisen können, müssen sie während der Montage des Kraftmoduls 20 zusammengedrückt werden. Dabei dürfen die Piezoaktoren 1 selbst nicht verkippen und müssen am Ende des Montageprozesses alle in festem Kontakt zur Deckplatte 12 des Kraftmoduls 20 stehen, weil sonst die Funktionalität des Kraftmoduls 20 nicht gewährleistet ist.

Vorteilhafterweise erfolgt die Montage der Deckplatte 12 in der Weise, dass in einem ersten Schritt die Deckplatte 12 mit einer geeigneten Pressvorrichtung behutsam auf Anschlag gefahren wird, d.h. die Deckplatte 12 liegt auf dem Kraftmodul-Gehäuseteil 11 unmittelbar auf. Dann werden die über den Umfang des Kraftmoduls eingebrachten Dehnungsschrauben 24 definierter Steifigkeit mit einem definierten Drehmoment angezogen und anschließend die Pressvorrichtung gelöst. Die Piezoaktoren federn im Bereich einiger Mikrometer zurück und zwischen Deckplatte 12 und Kraftmodul-Gehäuseteil 11 entsteht ein Luftspalt.

Vorteilhafterweise ist damit das Kraftmodul 20 bei hohen mechanischen Belastungen, z.B. typischen Stoßbelastungen, die bei Umformprozessen auftreten, in idealer Weise geschützt. Im Extremfall geht die Deckplatte 12 auf Anschlag zum Kraftmodul-Gehäuseteil 11, der Luftspalt schließt sich, begrenzt damit die Stauchung der Piezoaktoren 1 und verhindert deren Schädigung.

Eine Kontrolle über den Montagevorgang des Kraftmoduls 20, insbesondere darüber, ob alle Piezoaktoren in Kraftschluss mit der Deckplatte 12 stehen, kann über die schon erwähnte Impedanz - oder Ladungskontrollmethode erfolgen.

Mit dem Bezugszeichen 17 ist die elektrische Beschaltung im Ansteuerungs- und Sicherungsmodul 16, mit dem Bezugszeichen 18 die mediendichte Verschraubung des Anschlusskabels 19 am Kraftmodul 20 bezeichnet. Im Ansteuerungs- und Sicherungsmodul 16 kann in einer Ausführungsform auch für jeden Piezoaktor 1 ein Leistungsverstärker 23 (nur pauschal angedeutet) angeordnet sein.

## Patentansprüche

1. Kraftmodul (20) zur hochdynamischen Krafterzeugung zum Anschluss an einer Spannungsquelle, bestehend aus mindestens zwei Submodulen und einem Ansteuerungs- und Sicherungsmodul (16), wobei in jedem Submodul mindestens zwei Piezoaktoren (1) und deren elektrische Kontaktierungselemente zusammengefasst sind und die mindestens zwei Submodule zu dem Kraftmodul zusammengefasst und definiert angeordnet sind, damit sich das Kraftvermögen der einzelnen Piezoaktoren (1) addiert und hohe Gesamtkräfte erreicht werden, wobei alle elektrischen Kontaktierungselemente der Submodule (21) in das Ansteuerungs- und Sicherungsmodul (16) geführt sind und in den Submodulen keine elektronischen Bauteile angeordnet sind, sondern diese ausschließlich im Ansteuerungs- und Sicherungsmodul angeordnet sind und die elektrischen Kontaktierungselemente für jeden einzelnen Piezoaktor (1) im Submodul (21) zwei elektrische Leiterbahnen (2b) bereitstellen, so dass jeder Piezoaktor (1) im Submodul (21) einzeln ansteuerbar ist und in jedem Submodul die elektrischen Kontaktierungselemente ein Flexboard (2) mit Leiterbahnen (2b) sind und die Außenelektroden (1b) der Piezoaktoren (1) mit den Leiterbahnen (2b) elektrisch verbunden sind.

2. Kraftmodul nach Anspruch 1, **dadurch gekennzeichnet, dass** jedes Flexboard (2) endseitig mit einem Anschlussstecker (9) versehen ist.

3. Kraftmodul nach Anspruch 1 oder 2, **dadurch gekennzeichnet, dass** jedes Submodul (21) eingehaust ist und ein Gehäuseteil (7) mit Basisplatte (6) und Deckel (8) aufweist, um die Piezoaktoren (1) vor Umwelteinflüssen zu schützen und nur die elektrischen Kontaktierungselemente aus dem Gehäuse abgedichtet herauszuführen.

4. Kraftmodul nach einem der Ansprüche 1 bis 3, **dadurch gekennzeichnet, dass** zwischen den Piezoaktoren (1) in den Submodulen (21) keramische Materialien (22) eingebracht sind.

5. Kraftmodul nach einem der Ansprüche 1 bis 4, **dadurch gekennzeichnet, dass** alle Submodule (21) identisch aufgebaut sind.

6. Kraftmodul nach einem der Ansprüche 1 bis 5, **dadurch gekennzeichnet, dass** im Ansteuerungs- und Sicherungsmodul (16) für jeden einzelnen Piezoaktor (1) ein Leistungsverstärker (23) angeordnet ist.

7. Kraftmodul nach einem der Ansprüche 1 bis 6, **dadurch gekennzeichnet, dass** das Kraftmodul (20) ein Kraftmodul-Gehäuseteil (11) mit Grund- (10) und Deckplatte (12) aufweist, und alle Teile aus Stahl, insbesondere gehärtetem Stahl bestehen.

8. Kraftmodul nach Anspruch 7, **dadurch gekennzeichnet, dass** die Submodule (21) im Kraftmodul-Gehäuseteil (11) mit der Grund- (10) und Deckplatte (12) über Dehnungsschrauben (24) vorgespannt sind.

9. Kraftmodul nach einem der Ansprüche 1 bis 8, **dadurch gekennzeichnet, dass** am Kraftmodul (20) ein Anschlusskabel (19) befestigt ist, dessen elektrische Leiter in das Ansteuerungs- und Sicherungsmodul (16) geführt sind.

10. Verwendung eines Kraftmoduls (20) nach einem der Ansprüche 1 bis 9 zur Steuerung von Fließvorgängen durch lokale Klemmung bei mechanischen Umformprozessen in der Automobilindustrie.

## Claims

1. A force module (20) for generating force in a highly dynamic manner for connection to a voltage source, consisting of at least two sub-modules and an activation and protection module (16), wherein at least two piezo actuators (1) and their electrical contacting elements are combined in each sub-module and the at least two sub-modules are combined to form the force module and are arranged in a defined manner so that the force capacity of the individual piezo actuators (1) is added and high total forces are achieved, wherein all the electrical contacting elements of the sub-modules (21) are guided into the activation and protection module (16), and no electronic components are arranged in the sub-modules, but rather are arranged exclusively in the activation and protection module, and the electrical contacting elements for each individual piezo actuator (1) in the sub-module (21) provide two electrical printed conductors (2b) so that each piezo actuator (1) in the sub-module (21) can be activated individually, and in each sub-module the electrical contacting elements are a flexible board (2) with printed conductors (2b), and the outer electrodes (1b) of the piezo actuators (1) are electrically connected to the printed conductors (2b).

2. A force module according to claim 1, **characterised in that** each flexible board (2) is provided at an end with a connector plug (9).

3. A force module according to claim 1 or 2, **characterised in that** each sub-module (21) is encased and has a housing portion (7) with a base plate (6) and a cover (8) in order to protect the piezo actuators (1) from environmental influences and only guide the electrical contacting elements out of the housing in a sealed manner.

4. A force module according to one of claims 1 to 3, **characterised in that** ceramic materials (22) are introduced between the piezo actuators (1) in the sub-modules (21).

5. A force module according to one of claims 1 to 4, **characterised in that** all the sub-modules (21) are constructed identically.

6. A force module according to one of claims 1 to 5, **characterised in that** arranged in the activation and protection module (16) for each individual piezo actuator (1) there is a power amplifier (23).

7. A force module according to one of claims 1 to 6, **characterised in that** the force module (20) has a force-module housing portion (11) with a base plate (10) and cover plate (12), and all the portions consist of steel, in particular hardened steel.

8. A force module according to claim 7, **characterised in that** the sub-modules (21) are pre-stressed in the force-module housing portion (11) with the base plate (10) and cover plate (12) by way of expansion screws (24).

9. A force module according to one of claims 1 to 8, **characterised in that** secured to the force module (20) there is a connection cable (19), the electrical conductors of which are guided into the activation and protection module (16).

10. Use of a force module (20) according to one of claims 1 to 9 for the control of flow processes by means of local clamping in mechanical forming processes in the automobile industry.

## Revendications

1. Module de force (20) pour la génération hautement dynamique de forces, destiné à une connexion à une source de tension et constitué d'au moins deux sous-modules et d'un module de commande et de sécurité (16), sachant que dans chaque sous-module sont regroupés au moins deux piézoactionneurs (1) et leurs éléments de connexion électriques et que les sous-modules, au nombre d'au moins deux, sont regroupés pour former le module de force et sont disposés de façon définie pour que la capacité de force des différents piézoactionneurs (1) s'additionne et pour obtenir des forces totales élevées, tous les éléments de connexion électriques des sous-modules (21) étant guidés pour entrer dans le module de commande et de sécurité (16), et les sous-modules ne contenant aucun composant électronique, mais ces derniers étant disposés exclusivement dans le module de commande et de sécurité, et les éléments de connexion électriques fournissant deux pistes conductrices (2b) électriques pour chaque piézoactionneur (1) individuel dans le sous-module (21), de sorte que chaque piézoactionneur (1) dans le sous-module (21) peut être activé individuellement, et les éléments de connexion électriques dans chaque sous-module étant une carte flexible (2) dotée de pistes conductrices (2b), et les électrodes externes (1b) des piézoactionneurs (1) étant raccordées électriquement aux pistes conductrices (2b).

2. Module de force selon la revendication 1, **caractérisé en ce que** chaque carte flexible (2) est pourvue d'une fiche de connexion (9) à une extrémité.

3. Module de force selon la revendication 1 ou 2, **caractérisé en ce que** chaque sous-module (21) est entouré d'un boîtier et présente un élément de boîtier (7) comportant une plaque de base (6) et un couvercle (8) pour protéger les piézoactionneurs (1) contre les influences de l'environnement et guider uniquement les éléments de connexion électriques de façon étanche hors du boîtier.

4. Module de force selon l'une des revendications 1 à 3, **caractérisé en ce que** des matériaux céramiques (22) sont disposés entre les piézoactionneurs (1) dans les sous-modules (21).

5. Module de force selon l'une des revendications 1 à 4, **caractérisé en ce que** tous les sous-modules (21) présentent une structure identique.

6. Module de force selon l'une des revendications 1 à 5, **caractérisé en ce que** dans le module de commande et de sécurité (16), un amplificateur de puissance (23) est disposé pour chaque piézoactionneur (1) individuel.

7. Module de force selon l'une des revendications 1 à 6, **caractérisé en ce que** le module de force (20) présente un élément de boîtier de module de force (11) comportant une plaque de base (10) et une plaque de recouvrement (12), et tous les éléments sont constitués d'acier, en particulier d'acier trempé.

8. Module de force selon la revendication 7, **caractérisé en ce que** les sous-modules (21) dans l'élément de boîtier de module de force (11) sont mis sous précontrainte avec la plaque de base (10) et la plaque de recouvrement (12), par l'intermédiaire de vis d'allongement (24).

9. Module de force selon l'une des revendications 1 à 8, **caractérisé en ce qu'**est fixé au module de force (20), un câble de connexion (19) dont les conducteurs électriques sont guidés pour entrer dans le module de commande et de sécurité (16).

10. Utilisation d'un module de force selon l'une des revendications 1 à 9, pour la commande de processus de fluage par serrage local, lors de procédés de formage dans l'industrie automobile.
